# EUROPÄISCHE PATENTANMELDUNG

(11) **EP 4 567 848 A1**
(43) Veröffentlichungstag der Anmeldung: **11.06.2025**
(21) Anmeldenummer: 23214378.4
(22) Anmeldetag: 05.12.2023
(51) Int. Cl.: H01H 23/04, H02G 3/12, H03K 17/97

(54) **ANORDNUNG UMFASSEND EIN FUNKTIONSMODUL UND EIN SCHALTGERÄT SOWIE VERFAHREN ZUR MONTAGE**

(71) Anmelder: Albrecht Jung GmbH & Co. KG, 58579 Schalksmühle (DE)
(72) Erfinder: Era, Eduard, 58513 Lüdenscheid (DE)

(57) **Zusammenfassung**

Vorgestellt wird eine Anordnung umfassend ein Funktionsmodul F zum Einbau in eine Dose und ein manuell zu betätigendes Schaltgerät S der Gebäudeinstallationstechnik, welches Funktionsmodul F durch die Betätigung eines an dem Schaltgerät S angeschlossenen Betätigungselementes B eines Oberteils O des Schaltgerätes S beeinflussbar ist, wobei das Funktionsmodul F zumindest eine Schnittstelle aufweist, mittels welcher zumindest ein Aktor entsprechend einer Betätigung des Betätigungselements B ansteuerbar ist, wobei an dem Schaltgerät S mindestens ein Magnet M angeordnet ist, welcher bei Betätigung des Betätigungselementes B seine Position ändert, und dass das Funktionsmodul F einen Sensor zur Erfassung des Magnetfeldes aufweist, so dass die Änderung des Magnetfeldes bei Betätigung des Betätigungselementes B detektiert wird, wobei das Funktionsmodul F eine Auswerteeinheit aufweist, die dazu eingerichtet ist, in Abhängigkeit der sensierten Magnetfeldänderung zu identifizieren, um welche Schaltgeräteart es sich bei dem Schaltgerät S handelt, welche Identifikation in die Ansteuerung des Aktors einfließt, wobei das Schaltgerät S mindestens einen Schraubdom SD mit einer in ihn eingreifenden Schraube SC aufweist. Besonders dabei ist, dass das Funktionsmodul F mindestens eine, insbesondere kreisförmige, Durchgangsöffnung Ö aufweist, durch die das Funktionsmodul F mittels der in den Schraubdom SD eingreifenden Schraube SC an dem Schaltgerät S gehalten ist.

## Beschreibung

Die Erfindung betrifft eine Anordnung umfassend ein Funktionsmodul zum Einbau in eine Installationsdose und ein manuell zu betätigendes Schaltgerät der Gebäudeinstallationstechnik, welches Funktionsmodul durch die Betätigung eines an dem Schaltgerät angeschlossenen Betätigungselementes eines Oberteils des Schaltgerätes beeinflussbar ist, wobei das Funktionsmodul zumindest eine Schnittstelle aufweist, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert, und dass das Funktionsmodul einen Sensor zur Erfassung des Magnetfeldes aufweist, so dass die Änderung des Magnetfeldes bei Betätigung des Betätigungselementes detektiert wird, wobei das Funktionsmodul eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, wobei das Schaltgerät mindestens einen Schraubdom mit einer in ihn eingreifenden Schraube aufweist.

Die Erfindung betrifft ferner ein Verfahren zur Montage einer solchen Anordnung in eine Installationsdose.

Aus AT 525 242 B1 ist ein gattungsgemäßes Funktionsmodul zum Einbau in eine Installationsdose mit einem manuell zu betätigenden Schaltgerät der Gebäudeinstallationstechnik bekannt geworden. Ein solches Funktionsmodul ist durch die Betätigung eines an dem Schaltgerät angeschlossenen Betätigungselementes eines Oberteils des Schaltgerätes beeinflussbar, beispielsweise um Lampen zu schalten, zu dimmen oder um Jalousien zu steuern, und zwar auch fernbedienbar, beispielsweise via Endgerät. Hierzu weist das Funktionsmodul zumindest eine Schnittstelle auf, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert. Ferner weist das Funktionsmodul einen Sensor zur Erfassung des Magnetfeldes auf, so dass die Änderung des Magnetfeldes bei Betätigung des Betätigungselementes detektiert wird. Es versteht sich, dass das Funktionsmodul auf über ein Endgerät, insbesondere ein mobiles Endgerät, beeinflussbar ist, um auf komfortable Weise bedient werden zu können. Ein solches, vorbekanntes Funktionsmodul umfasst zudem eine Auswerteeinheit zur Auswertung der Magnetfeldänderung, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, so dass ein Austausch von Schaltern durch Taster vermieden wird. So erfordert das Dimmen einer Lampe mit einem Funktionsmodul beispielsweise eine spezifische Ansteuerung, je nachdem, ob das zugrundeliegende Schaltgerät ein Taster oder ein Schalter ist. Daher ist die Identifikation der Schaltgeräteart durch die Auswerteeinheit ein weiterer Vorteil eines solchen Funktionsmoduls.

Durch ein solches, vorbekanntes Funktionsmodul kann der Installationsaufwand mit Blick auf den zu leistenden Verkabelungsaufwand, wie er bei herkömmlichen Funktionsmodulen ohne Sensierung der Magnetfeldänderung erforderlich ist - hierbei werden Kabel zwischen Schaltgerät und Funktionsmodul (nachfolgend fliegende Verkabelung genannt) angeschlossen, um die Betätigung elektrisch zu übermitteln - signifikant verringert werden, da Funktionsmodul und Schaltgerät magnetisch miteinander kommunizieren; ein elektrischer Anschluss des Funktionsmoduls an das Schaltgerät mithin obsolet geworden ist.

Problematisch bei solchen vorbekannten gattungsgemäßen Anordnungen ist jedoch, dass die Montage des Funktionsmoduls in der Unterputzdose verkompliziert wird, da das Funktionsmodul beim Einsetzen in die Dose seine Position ändert, regelmäßig Kabelgut berührt/blockiert und zu einer nicht wohldefinierten Position des Sensors bezüglich des Magneten führt, was sich nachteilig auf die Detektionszuverlässigkeit auswirken kann.

Darüber hinaus hat sich gezeigt, dass durch das gemeinsame Einsetzen des Funktionsmoduls - wenn es formschlüssig mit dem Schaltgerät verbunden ist - in die Installationsdose dort befindliches Kabelgut bei engen Platzverhältnissen, insbesondere flachen Installationsdosen, beschädigt werden kann, da es zu einem Klemmen zwischen Funktionsmodul und Kabelgut kommt.

Ausgehend von diesem diskutierten Stand der Technik liegt der Erfindung die Aufgabe zugrunde, eine Anordnung umfassend ein Funktionsmodul zum Einbau in eine Installationsdose und ein manuell zu betätigendes Schaltgerät vorzuschlagen, wobei die vorstehend genannten Nachteile vermieden sind. Insbesondere soll die Einfachheit der Montage verbessert werden, ohne dass die Herstellungskosten substanziell angehoben werden. Gleichzeitig soll das Risiko, dass beim Einsetzen des Funktionsmoduls mit dem Schaltgerät in die Installationsdose das Kabelgut beschädigt wird, minimiert werden.

Gelöst wird diese Aufgabe durch eine Anordnung umfassend ein Funktionsmodul zum Einbau in eine Installationsdose und ein manuell zu betätigendes Schaltgerät, wobei das Funktionsmodul mindestens eine, insbesondere kreisförmige, Durchgangsöffnung aufweist, durch die das Funktionsmodul mittels einer in den Schraubdom eingreifenden Schraube an dem Schaltgerät gehalten ist.

Der Kerngedanke der Erfindung besteht darin, dass bei der erfindungsgemäßen Anordnung das Funktionsmodul mindestens eine, insbesondere kreisförmige, Durchgangsöffnung aufweist. Durch diese kann das Funktionsmodul mittels einer in den Schraubdom eingreifenden Schraube an dem Schaltgerät gehalten sein.

Besonders vorteilhaft und geschickt dabei ist, dass die bereits vorhandene Schraube und/oder der bereits am Schaltgerät vorhandene Schraubdom hierfür genutzt werden können, so dass insbesondere im Gegensatz zu einem Kleben des Funktionsmoduls an das Schaltgerät Mehrkosten für Material gerade nicht anfallen und die Art der Befestigung besonders einfach, intuitiv, langlebig und reversibel ist.

In einer besonders bevorzugten Ausführungsform weist die Schraube mit ihrem Schraubenkopf in Richtung des Oberteils und greift mit ihrem Gewinde teilweise in einen Funktionsmodulschraubdom ein. Bei dieser Ausführungsform wird die Schraube so tief durch den Schraubdom (der zur zum Boden der Installationsdose weisenden Seite offen ist) eingedreht, dass ein Teil des Gewindes in den Funktionsmodulschraubdom eingreift, so dass Funktionsmodul und Schaltgerät besonders einfach verbunden sind.

In einer besonders bevorzugten alternativen Ausführungsform weist die Schraube mit ihrem Schraubenkopf in Richtung des Bodens der Installationsdose, wobei sie mit ihrem Gewinde teilweise in den Schraubdom des Schaltgerätes eingreift. Insofern erfolgt die Befestigung gerade andersherum als in der vorstehend beschriebenen Ausführungsform. Diese Ausführungsform geht mit dem Vorteil einher, dass die Schraube des Schaltgerätes, die regelmäßig zur Einstellung der Spreizkrallen vorhanden ist, erhalten bleibt (wenn sie ausreichend kurz ist beziehungsweise der Schraubdom ausreichen lang ist), da die Schraube zur Festlegung des Funktionsmoduls gerade von der anderen Seite des Schraubdoms in denselben Schraubdom eingedreht wird; mithin der Schraubdom doppelt genutzt wird (einmal für die Einstellung der Spreizkrallen und einmal zur Festlegung des Funktionsmoduls am Schaltgerät).

In einer weiteren Ausgestaltung der Erfindung ist der Magnet in einen Steckplatz des Oberteils des Schaltgerätes eingesetzt. Gemäß einer bevorzugten Ausgestaltung der erfindungsgemäßen Anordnung ist der Magnet so dimensioniert, dass dieser unter Vorspannung stehend in den Steckplatz des Oberteils des Schaltgerätes eingesetzt ist. Hierdurch wird ein Verrutschen oder Herausfallen des Magneten aus dem Oberteil wirksam vermieden. In einer bevorzugten alternativen Ausgestaltung der erfindungsgemäßen Anordnung ist der Steckplatz so in das Oberteil integriert, dass das Aufnahmevolumen für den Magneten als Teilmenge des Volumens des Oberteils ausgeführt ist, so dass der Magnet bauraumneutral in den Steckplatz einsetzbar ist. Anders ausgedrückt, ist der Magnet vollständig in dem Oberteil aufgenommen, so dass kein Abschnitt des Magneten außerhalb des Oberteils liegt. Gemäß einer weiteren alternativen Ausgestaltung der erfindungsgemäßen Anordnung ist der Magnet in einem, in den Steckplatz eingesetzten, Magnetgehäuse aufgenommen. Hierdurch wird der Vorteil erreicht, dass der Magnet eine einfache Quaderform aufweisen kann, mithin einfach und kostengünstig herstellbar beziehungsweise beschaffbar ist, und das Magnetgehäuse als Adapter zur Einpassung in und Festlegung an den Steckplatz fungiert. Gemäß einer weiteren alternativen Ausgestaltung der erfindungsgemäßen Anordnung ist der Magnet durch einen Magnethalter, der an das Oberteil angeschlossen, insbesondere verrastet, ist, in dem Steckplatz gehalten. Hierdurch wird ebenfalls ermöglicht, dass der Magnet eine einfache Quaderform aufweisen kann, mithin einfach und kostengünstig herstellbar beziehungsweise beschaffbar ist, da vermieden ist, dass der Magnet aus dem Steckplatz herausfällt. In einer bevorzugten Ausgestaltung der erfindungsgemäßen Anordnung weist der Magnet ein Volumen im Bereich von 10 bis 250 mm³ auf. Hierdurch wird gleichzeitig eine gute Handhabung des Magneten, ein gutes Signal-zu-Rausch-Verhältnis bezüglich des Sensors und eine kompakte Bauform des Magneten erreicht.

Durch die intelligente erfindungsgemäße Gestaltung des Gehäuses in einer bevorzugten Ausführungsform der Erfindung wird erreicht, dass die effektive Einbautiefe des Funktionsmoduls in der Installationsdose hinter das Schaltgerät insofern verringert wird, als dass das Gehäuse des Funktionsmoduls mindestens eine, regelmäßig zwei, Ausnehmung(en) aufweist, die mit Vorsprüngen des Schaltgerätes in Eingriff gestellt ist/sind. Dadurch, dass die Ausnehmung vorzugsweise lediglich in dem Bereich der zwei Haltevorrichtungen, insbesondere der Schraubdome zur Spreizung von Spreizkrallen zur Festlegung des Schaltgerätes in der Installationsdose, vorgesehen ist, wird das Volumen des Funktionsmoduls nur unwesentlich verringert, der effektive Bauraumbedarf jedoch entscheidend abgesenkt. Gemäß einer besonders bevorzugten Ausgestaltung dieses erfindungsgemäßen Funktionsmoduls ist die mindestens eine Ausnehmung mindestens teilweise komplementär zu den Vorsprüngen, insbesondere im Bereich der Haltevorrichtungen, des Schaltgerätes, wobei die mindestens eine Durchgangsöffnung im Bereich der mindestens einen Ausnehmung angeordnet ist. Eine solche Ausgestaltung erlaubt es, das Volumen des Funktionsmoduls zu maximieren und den Einbautiefenverlust zu minimieren, indem der Bereich des Funktionsmoduls mit geringer Höhe geschickt für die Durchgangsöffnung/Festlegung genutzt wird, während der Bereich der großen Höhe des Funktionsmoduls für elektrische Komponenten wie Relais und/oder Dimmer zur Verfügung stehen.

Die Erfindung betrifft ferner eine Anordnung umfassend ein erfindungsgemäßes Funktionsmodul und ein Schaltgerät, insbesondere einen Schalter oder einen Taster, wobei das Funktionsmodul mit seinen Ausnehmungen in Eingriff mit den Vorsprüngen des Schaltgerätes gestellt ist.

Die Erfindung betrifft ferner ein Verfahren zur Montage einer erfindungsgemäßen Anordnung in eine Installationsdose, umfassend die folgenden Schritte:
- Elektrischer Anschluss des Funktionsmoduls über die Schnittstelle an eine Energieversorgungsleitung und/oder Steuerleitungen,
- Fixieren des Funktionsmoduls mittels der in den Schraubdom eingreifenden Schraube an dem Schaltgerät,
- Einsetzen des Funktionsmoduls und des Schaltgerätes in die Installationsdose,
- Aufsetzen des Betätigungselementes auf das Oberteil.

In einem ersten Schritt wird dabei das Funktionsmodul über die Schnittstelle an eine Energieversorgungsleitung und/oder Steuerleitungen (zur Beeinflussung einer Leuchte, Jalousie oder dergleichen) angeschlossen. Dieses umfasst regelmäßig den Anschluss an den Außenleiter und gegebenenfalls den Neutralleiter.

In einem zweiten Schritt wird das Funktionsmodul mittels der in den Schraubdom eingreifenden Schraube an dem Schaltgerät fixiert.

In einem dritten Schritt wird die erfindungsgemäße Anordnung, umfassend das Funktionsmodul und das Schaltgerät in die Installationsdose eingesetzt.

In einem vierten Schritt wird das Betätigungselement auf das Oberteil aufgesetzt.

Nachfolgend ist die Erfindung unter Bezugnahme auf die beigefügten Figuren anhand diverser Ausführungsbeispiele beschrieben. Es zeigen:
- **Fig. 1:**: eine schematische Seitenansicht einer erfindungsgemäßen Anordnung in einer flachen Installationsdose,
- **Fig. 2:**: eine Draufsicht (links) beziehungsweise perspektivische Ansicht auf das Schaltgerät (hier zweikanalig ausgeführt) der erfindungsgemäßen Anordnung (ohne Betätigungselement und Funktionsmodul),
- **Fig. 3:**: eine perspektivische Ansicht eines Magnetgehäuses, in das der Magnet aufgenommen werden kann,
- **Fig. 4:**: eine Draufsicht (links) beziehungsweise perspektivische Ansicht auf das Schaltgerät (hier einkanalig ausgeführt) der erfindungsgemäßen Anordnung (ohne Betätigungselement und Funktionsmodul), und
- **Fig. 5:**: eine perspektivische Ansicht eines Magnethalters zum Festlegen an dem Oberteil, so dass ein Herausfallen des Magneten aus dem Steckplatz vermieden ist.

In den verschiedenen Figuren sind gleiche Teile stets mit den gleichen Bezugszeichen versehen und werden daher in der Regel auch jeweils nur einmal benannt beziehungsweise erwähnt.

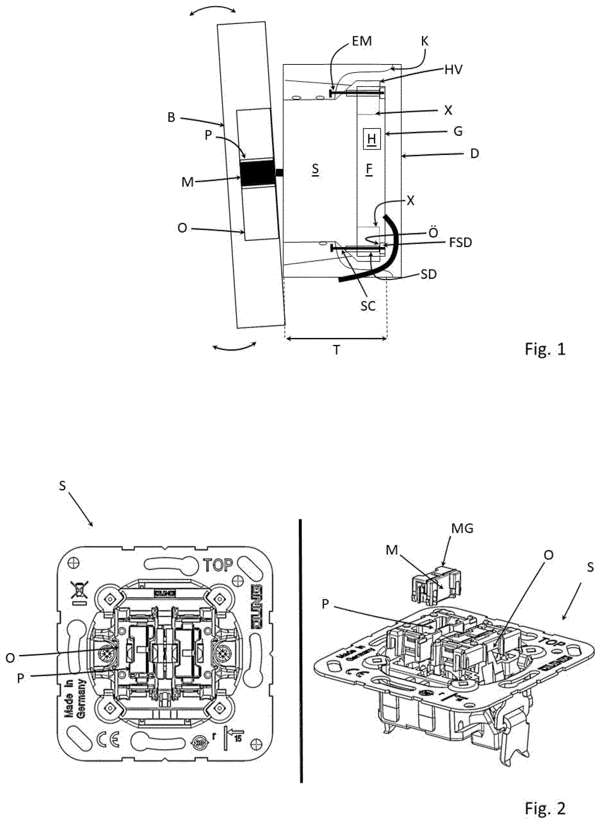

Figur 1 zeigt eine schematische Seitenansicht einer erfindungsgemäßen Anordnung mit einem Schaltgerät S in einer flachen Installationsdose mit angedeuteten Funktionsmodul F, wobei insgesamt die Einbautiefe T beansprucht wird. Dabei weist das Gehäuse des Funktionsmoduls mindestens eine Ausnehmung X auf, die mit den Vorsprüngen HV des Schaltgerätes S in Eingriff gestellt ist. Solche Vorsprünge HV erstrecken sich regelmäßig in Richtung des Bodens der Installationsdose D und dienen als Haltevorrichtung, in die Schraubdome eingesetzt sind, um die mittels Einstellmitteln EM verstellbaren Spreizkrallen K zur Festlegung des Schaltgerätes S an der Installationsdose D sicherzustellen.

Zur Detektion der Betätigung des Betätigungselmentes B, das regelmäßig als Wippe ausgeführt ist und auf einem Oberteil (auch Wippenaufnahme genannt) angeordnet ist, befindet sich bei der erfindungsgemäßen Anordnung in einem Steckplatz P ein Magnet M. Durch die durch den Magnetfeldsensor H erfasste Änderung des Magnetfeldes bei einer Betätigung des Betätigungselementes B, das insbesondere ein Kippen des Oberteils O nach sich zieht, wird identifiziert, um welche Schaltgeräteart es sich bei dem Schaltgerät S handelt, welche Identifikation in die funktionsmodulseitige Ansteuerung eines Aktors einfließt. Beispielsweise springt ein Taster in die Ursprungsstellung zurück, während ein Schalter in seiner angenommenen Stellung verbleibt.

Vorteilhaft bei der erfindungsgemäßen Anordnung ist, dass der Magnet M im Steckplatz P besonders unschädlich für die Bedienung angeordnet ist, da im Vergleich zu einer Anordnung auf der Rückseite des Oberteils keine Blockade, beispielsweise durch ein Stoßen des Magneten M an einen Tragring oder eine Installationsdose D, beim Kippen des Oberteils O auftreten kann.

Besonders bei der erfindungsgemäßen Anordnung ist, dass das Funktionsmodul F mindestens eine, insbesondere kreisförmige, Durchgangsöffnung Ö aufweist, durch die das Funktionsmodul F mittels der in den Schraubdom SD eingreifenden Schraube SC an dem Schaltgerät S gehalten ist. Wie in Figur 1 gezeigt, weist die Schraube SC mit ihrem Schraubenkopf in Richtung des Oberteils O und greift mit ihrem Gewinde teilweise in einen Funktionsmodulschraubdom FSD ein.

Figur 2 zeigt eine Draufsicht (links) beziehungsweise perspektivische Ansicht auf das Schaltgerät S (hier zweikanalig ausgeführt) der erfindungsgemäßen Anordnung (der Einfachheit halber ohne Betätigungselement B und Funktionsmodul F). Besonders vorteilhaft an der dargestellten Ausführungsform ist, dass durch das Magnetgehäuse MG, das als Adapter fungiert, indem es den Magneten M aufnehmbar und in den Steckplatz P einsetzbar macht, ein Magnet M beliebiger Form, insbesondere einer günstig herstellbaren quaderförmigen Form, nutzbar gemacht wird.

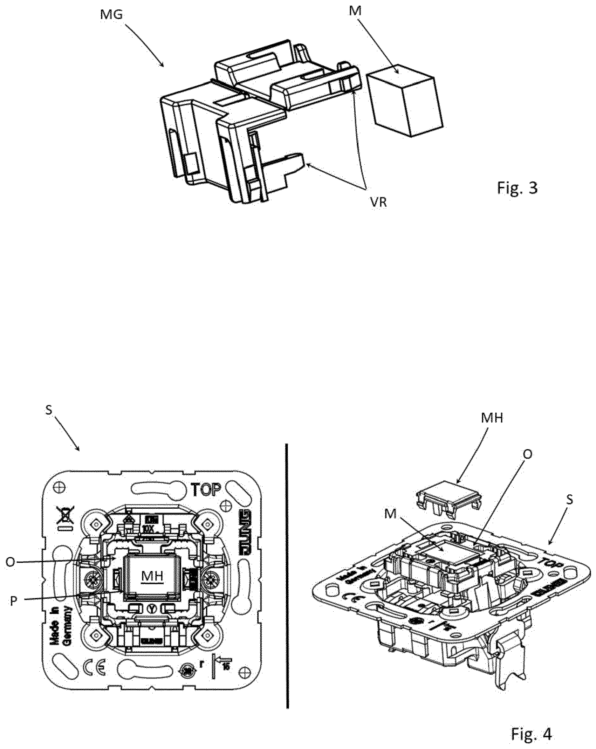

Ein solches in Figur 3 gezeigtes Magnetgehäuse MG kann beispielsweise so ausgeführt sein, dass es eine Außenkontur aufweist, die jedenfalls teilweise an die Innenkontur des Steckplatzes P angepasst ist. Zur Aufnahme eines beispielsweise quaderförmigen Magneten M, kann das Gehäuse eine Achse aufweisen, um die das Gehäuse mit einem Deckel und einem Boden schwenkkbar ausgeführt ist. Die Festlegung des Magnetgehäuses an dem Oberteil, insbesondere dem Steckplatz P, kann durch Verrastungsstrukturen VR erfolgen.

Figur 4 zeigt eine Draufsicht (links) beziehungsweise perspektivische Ansicht auf das Schaltgerät S (hier einkanalig ausgeführt) der erfindungsgemäßen Anordnung (ohne Betätigungselement B und Funktionsmodul F). In einer alternativen Ausführungsform der Erfindung ist der Magnet M in dem Steckplatz P gehalten, indem ein Magnethalter MH an das Oberteil O angeschlossen, insbesondere auf die Öffnung des Steckplatzes P aufgerastet ist.

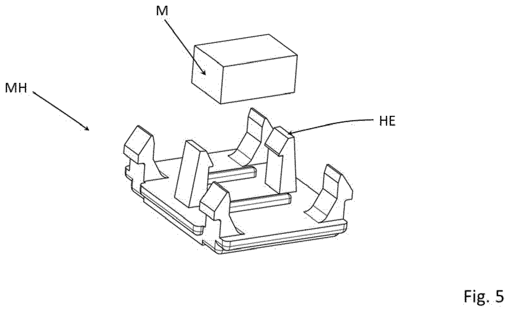

Ein solcher Magnethalter MH ist perspektivisch in Figur 5 gezeigt. Durch den Magnethalter MH zum Festlegen an dem Oberteil O wird ein Herausfallen des Magneten M aus dem Steckplatz P wirksam vermieden. Dabei kann der Magnethalter MH durch Verrastungsstrukturen VR an dem Oberteil O, insbesondere der Öffnung des Steckplatzes P, festgelegt sein. Zudem kann der Magnethalter MH Halteelemente HE für den Magneten M aufweisen, so dass jegliches Wackeln des Magneten M ausgeschlossen ist, was ansonsten als Fehlbetätigung durch den Magnetfeldsensor H identifiziert werden könnte.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- B: Betätigungselement
- D: Installationsdose
- EM: Einstellmittel
- F: Funktionsmodul
- FSD: Funktionsmodulschraubdom
- G: Gehäuse
- H: Sensor
- HV: Vorsprünge
- HE: Halteelement
- K: Spreizkralle
- M: Magnet
- MG: Magnetgehäuse
- MH: Magnethalter
- O: Oberteil
- Ö: Durchgangsöffnung
- P: Steckplatz
- S: Schaltgerät
- SC: Schraube
- SD: Schraubdom
- T: Einbautiefe
- VR: Verrastungsstruktur
- X: Ausnehmung

## Patentansprüche

1. Anordnung umfassend ein Funktionsmodul (F) zum Einbau in eine Installationsdose (D) und ein manuell zu betätigendes Schaltgerät (S) der Gebäudeinstallationstechnik, welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, wobei an dem Schaltgerät (S) mindestens ein Magnet (M) angeordnet ist, welcher bei Betätigung des Betätigungselementes (B) seine Position ändert, und dass das Funktionsmodul (F) einen Sensor zur Erfassung des Magnetfeldes aufweist, so dass die Änderung des Magnetfeldes bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, wobei das Schaltgerät (S) mindestens einen Schraubdom (SD) mit einer in ihn eingreifenden Schraube (SC) aufweist, **dadurch gekennzeichnet, dass** das Funktionsmodul (F) mindestens eine, insbesondere kreisförmige, Durchgangsöffnung (Ö) aufweist, durch die das Funktionsmodul (F) mittels der in den Schraubdom (SD) eingreifenden Schraube (SC) an dem Schaltgerät (S) gehalten ist.

2. Anordnung nach Anspruch 1, **dadurch gekennzeichnet, dass** die Schraube (SC) mit ihrem Schraubenkopf in Richtung des Oberteils (O) weist und mit ihrem Gewinde teilweise in einen Funktionsmodulschraubdom (FSD) eingreift.

3. Anordnung nach Anspruch 1, **dadurch gekennzeichnet, dass** die Schraube (SC) mit ihrem Schraubenkopf in Richtung des Bodens der Installationsdose (D) weist und mit ihrem Gewinde teilweise in den Schraubdom (SD) des Schaltgerätes (S) eingreift.

4. Anordnung nach einem der Ansprüche 1 bis 3, **dadurch gekennzeichnet, dass** der Magnet (M) in einen Steckplatz (P) des Oberteils (O) des Schaltgerätes (S) eingesetzt ist.

5. Anordnung nach Anspruch 4, **dadurch gekennzeichnet, dass** der Magnet (M) so dimensioniert ist, dass dieser unter Vorspannung stehend in den Steckplatz (P) des Oberteils (O) des Schaltgerätes (S) einsetzt ist.

6. Anordnung nach Anspruch 4, **dadurch gekennzeichnet, dass** der Magnet (M) in einem, in den Steckplatz (P) eingesetzten, Magnetgehäuse (MG) aufgenommen ist.

7. Anordnung nach Anspruch 4, **dadurch gekennzeichnet, dass** der Magnet (M) durch einen Magnethalter (MH), der an das Oberteil (O) angeschlossen, insbesondere verrastet ist, in dem Steckplatz (P) gehalten ist.

8. Anordnung nach einem der Ansprüche 4 bis 7, **dadurch gekennzeichnet, dass** der Magnet (M) ein Volumen im Bereich von 10 bis 250 mm³ aufweist.

9. Anordnung nach einem der Ansprüche 1 bis 8 **dadurch gekennzeichnet, dass** das Funktionsmodul (F) ein Gehäuse (G) aufweist, welches eine Schnittstelle mit Anschlüssen aufweist, wobei das Gehäuse (G) mindestens eine Ausnehmung (X) aufweist, die mit Vorsprüngen (HV) des Schaltgerätes (S) in Eingriff gestellt ist, so dass die effektive Einbautiefe (T) des Funktionsmoduls in der Installationsdose hinter dem Schaltgerät (S) verringert und das Funktionsmodul (F) positionsfixiert wird.

10. Anordnung nach Anspruch 9, **dadurch gekennzeichnet, dass** die mindestens eine Ausnehmung (X) mindestens teilweise komplementär zu den Vorsprüngen (HV) des Schaltgerätes (S) ist, wobei die mindestens eine Durchgangsöffnung (Ö) im Bereich der mindestens einen Ausnehmung (X) angeordnet ist.

11. Verfahren zur Montage einer Anordnung gemäß einem der Ansprüche 1 bis 10 in einer Installationsdose (D), umfassend die folgenden Schritte:
- Elektrischer Anschluss des Funktionsmoduls (F) über die Schnittstelle an eine Energieversorgungsleitung und/oder Steuerleitungen,
- Fixieren des Funktionsmoduls (F) mittels der in den Schraubdom (SD) eingreifenden Schraube (SC) an dem Schaltgerät (S),
- Einsetzen des Funktionsmoduls (F) und des Schaltgerätes (S) in die Installationsdose (D),
- Aufsetzen des Betätigungselementes (B) auf das Oberteil (O).
